# EUROPEAN PATENT APPLICATION

(11) **EP 2 391 007 A2**
(43) Date of publication of application: **30.11.2011**
(21) Application number: 11167241.6
(22) Date of filing: 24.05.2011
(51) Int. Cl.: H03K 5/151, H03K 23/54

(54) **Division circuit, division device, and electronic apparatus**

(30) Priority: 26.05.2010 JP 2010120178
(71) Applicant: Seiko Epson Corporation, Tokyo 163-0811 (JP)
(72) Inventor: Orii, Toshio, Nagano 392-8502 (JP)
(74) Representative: HOFFMANN EITLE

(57) **Abstract**

A division circuit includes: a division unit that generates a divided signal by dividing the frequency of an input signal on the basis of a clock signal having the same frequency as that of the input signal and an inverted clock signal being synchronized with the clock signal but having an inverted phase, of which both clock signals are generated from the input signal; i and an output signal generator that generates an output signal on the basis of the divided signal having the same frequency as that of the divided signal and an inverted output signal being synchronized with the output signal but having an inverted phase, of which both output signals are generated from the divided signal.

## Description

### BACKGROUND

### 1. Technical Field

The present invention relates to a division circuit, a division device, and an electronic apparatus.

### 2. Related Art

Electronic apparatuses such as a GPS receiver use a division circuit that divides the frequency of an oscillation signal from an internal oscillator to obtain a signal of a predetermined frequency (for example, see JP-A-2008-187556) . The division circuit generally has a configuration in which plural division circuits each dividing the frequency of an input signal by half are cascaded, since the circuit configuration thereof is generally simple.

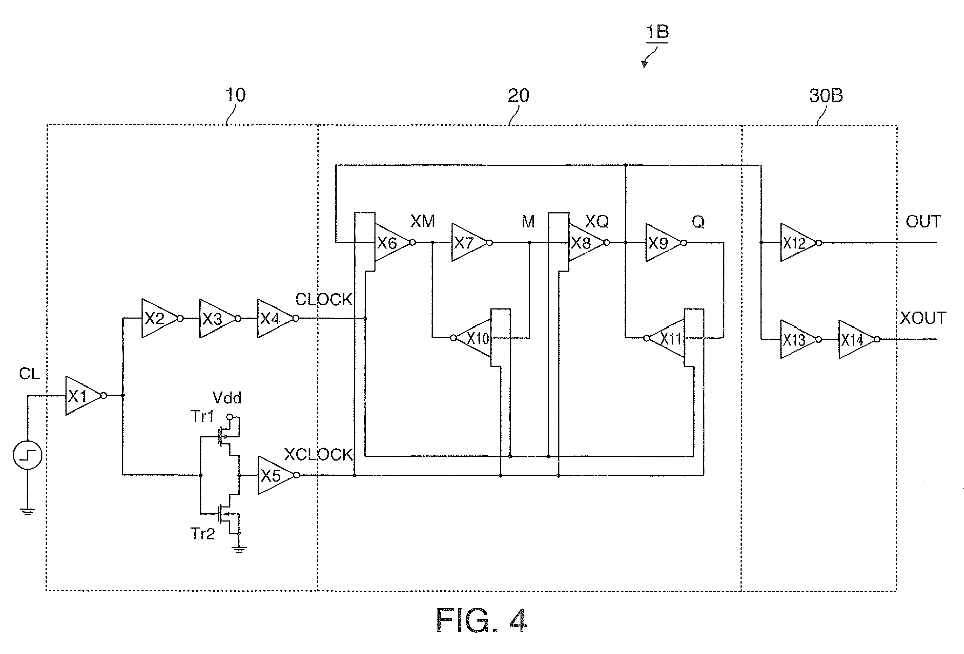

Fig. 4 is a diagram illustrating the circuit configuration of a division circuit 1B according to the related art. As shown in Fig. 4, the division circuit 1B is a circuit that outputs an output signal OUT obtained by dividing the frequency of an input signal CL by half and an inverted signal XOUT thereof and includes (1) a clock signal generator 10, (2) a divided signal generator 20, and (3) an output signal generator 30B.

The clock signal generator 10 generates clock signals CLOCK and XCLOCK having the same frequency as that of the input signal CL and having inverted phases on the basis of the input signal CL. The divided signal generator 20 generates an inverted divided signal XQ of which the frequency is a half of the frequency of the input signal CL on the basis of the clock signals CLOCK and XCLOCK. The output signal generator 30B generates output signals OUT and XOUT having a frequency which is a half of the frequency of the input signal CL and having opposite phases on the basis of the inverted divided signal XQ.

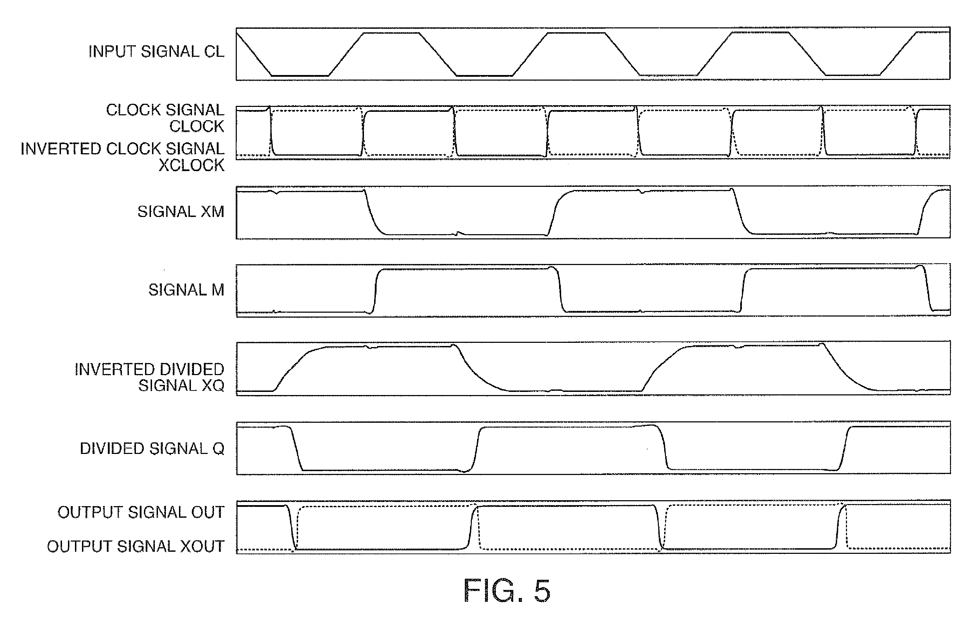

Fig. 5 is a diagram illustrating signal waveforms in the division circuit IB. In Fig. 5, the horizontal axis represents the time t and the vertical axis represents, as signal levels, signal waveforms of the input signal CL, the clock signals CLOCK and XCLOCK, an output signal XM of a clocked inverter X6, an output signal M of an inverter X7, the inverted divided signal XQ, an output signal Q of an inverter X9, and the output signals OUT and XOUT sequentially from the upper end.

However, in the division circuit 1B shown in Fig. 4, a signal obtained by inverting and amplifying the inverted divided signal XQ, which is obtained by dividing the frequency of the input signal CL by half, by the use of an inverter X12 is output as the output signal OUT. A signal obtained by inverting and amplifying the inverted divided signal XQ by the use of cascaded inverters X13 and X14 is output as the inverted output signal XOUT. That is, the signal obtained by passing the inverted divided signal XQ through the single inverter X12 is output as the output signal OUT and a signal obtained by passing the inverted divided signal XQ through the two inverters X13 and X14 is output as the inverted output signal XOUT. Accordingly, as shown in Fig. 5, the phases of the output signals OUT and XOUT are deviated from each other.

When plural stages of division circuits are connected in series, the output signals OUT and XOUT are input as the clock signals CLOCK and XCLOCK of the next stage so as to reduce the number of elements in the overall circuit. At this time, when the phases of the output signals OUT and XOUT are deviated from each other, a period of time when the clock signals CLOCK and XCLOCK in the next stage of division circuit are simultaneously switched to a "H" level exists, which causes an erroneous operation.

### SUMMARY

An advantage of some aspects of the invention is that it provides a division circuit which can generate and output an output signal and an inverted signal thereof phase-locked to each other.

According to a first aspect of the invention, there is provided a division circuit including: a division unit that generates a divided signal by dividing the frequency of an input signal on the basis of a clock signal and an inverted clock signal having the same frequency as that of the input signal and having locked but inverted phases, of which both clock signals are generated from the input signal; and an output signal generator that generates an output signal and an inverted output signal having the same frequency as that of the divided signal and having locked but inverted phases using the clock signal and the inverted clock signal on the basis of the divided signal.

According to this configuration, it is possible to implement the division circuit that generates and outputs the output signal and the inverted output signal having the same frequency as that of the divided signal and having the locked but inverted phases.

In a second aspect of the invention, the output signal generator may include a clocked inverter operating in response to the clock signal so as to lock the phase of the output signal and the phase of the inverted output signal.

According to the second aspect, the output signal and the inverted output signal having the locked phase are generated by the use of the clocked inverter operating in response to the clock signal.

In a third aspect of the invention, the output signal generator may further include a level holder that holds the output level of the clocked inverter.

According to the third aspect, the immediately previous output level of the clocked inverter is held even when the clocked inverter does not operate.

In a fourth aspect of the invention, the level holder may hold the output level by the use of a gate capacitor or a wiring capacitor of a transistor included in the level holder.

According to a fifth aspect of the invention, there is provided a division device in which N-stage (where N is an integer equal to or greater than 2) dividers are cascaded, wherein the first-stage divider includes a clock signal generator that generates the clock signal and the inverted clock signal on the basis of the input signal, and the division circuit according to anyone of the first to fourth aspects, and wherein the nth-stage (where n==2, 3, ..., N) divider includes the division circuit according to any one of the first to fourth aspects that receives the output signal output from the (n-1)th-stage divider as the clock signal and receives the inverted output signal thereof as the inverted clock signal.

According to the fifth aspect, in the division device in which a plurality of dividers are cascaded, the output signal and the inverted output signal output from a divider can be input as the clock signal and the inverted clock signal of the next-stage divider, respectively.

According to a sixth aspect of the invention, there is provided an electronic apparatus including the division circuit according to any one of the first to fourth aspects or the division device according to the fifth aspect.

### BRIEF DESCRIPTION OF THE DRAWINGS

The invention will be described with reference to the accompanying drawings, wherein like numbers reference like elements.

Fig. 1 is a diagram illustrating the circuit configuration of a division circuit according to an exemplary embodiment of the invention.

Fig. 2 is a diagram illustrating signal waveforms in the division circuit.

Fig. 3 is a diagram illustrating the circuit configuration of a division circuit additionally including a set/reset circuit.

Fig. 4 is a diagram illustrating the circuit configuration of a division circuit according to the related art.

Fig. 5 is a diagram illustrating signal waveforms in the division circuit according to the related art.

### DESCRIPTION OF EXEMPLARY EMBODIMENTS

Hereinafter, an exemplary embodiment of the invention will be described with reference to the accompanying drawings.

### Configuration

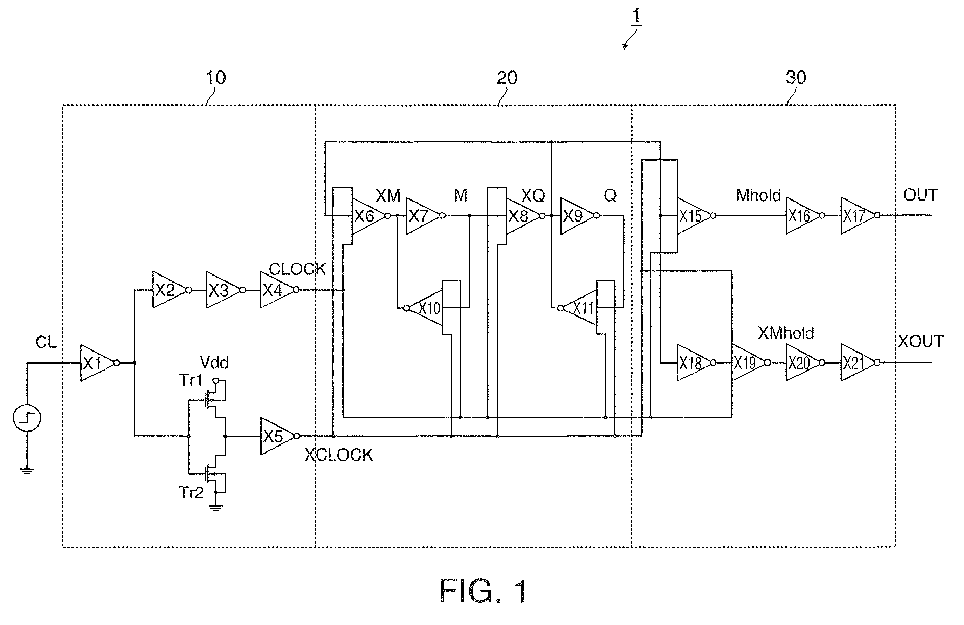

Fig. 1 is a diagram illustrating the circuit configuration of a division circuit 1 according to an exemplary embodiment of the invention. In Fig. 1, the elements common to the division circuit 1B according to the related art shown in Fig. 4 are referenced by the same reference numerals and signs. The division circuit 1 generates and outputs an output signal OUT obtained by dividing the frequency of an input signal CL by half (half-division) and an inverted signal XOUT having the same frequency as that of the output signal OUT and having the inverted phase (output signals OUT and OUT) . The division circuit 1 includes (1) a clock signal generator 10, (2) a divided signal generator 20 (division unit) , and (3) an output signal generator 30.

The clock signal generator 10 generates a clock signal CLOCK having the same frequency as that of the input signal CL and a phase locked thereto and an inverted signal XCLOCK having the same frequency as that of the clock signal CLOCK but the inverted phase thereof (clock signals CLOCK and XCLOCK) . The clock signal generator 10 includes inverters X1, X2, X3, X4, and X5 and transistors Tr1 and Tr2.

The divided signal generator 20 generates an inverted divided signal XQ by dividing the frequency of the input signal CL by half on the basis of the clock signals CLOCK and XCLOCK generated from the clock signal generator 1.0. The divided signal generator 20 includes clocked inverters X6, X8, X10, and X11 and inverters X7 and X9.

The clocked inverter X6 receives the clock signal CLOCK as a control signal, inversely amplifies the inverted divided signal XQ, and outputs as a signal XM. The signal XM is inversely amplified by the inverter X'7 and is output as a signal M. The clocked inverter X10 receives the inverted clock signal XCLOCK as a control signal, inversely amplifies the signal M, and outputs as a signal XM.

The clocked inverter X10 serves as a level holding circuit for the signal XM. That is, when the clocked inverter X6 is in operation, the clocked inverter X10 is out of operation and the inverted signal of the inverted divided signal XQ is output as the signal XM by the clocked inverter X6. On the other hand, when the clocked inverter X6 is out of operation, the clocked inverter X10 is in operation and the inverted signal of the signal M is output as the signal XM by the clocked inverter X10 . That is, when the clocked inverter X6 is out of operation, the level of the signal XM just before the clocked inverter X6 is out of operation is maintained by the clocked inverter X1.U .

The clocked inverter X8 receives the clock signal XCLOCK as a control signal, inversely amplifies the signal M, and outputs as the inverted divided signal XQ. The inverted divided signal XQ is inversely amplified by the inverter X9 and is output as the divided signal Q. The clocked inverter X11 receives clock signal CLOCK as a control signal, inversely amplifies the divided signal Q, and outputs as the inverted divided signal XQ.

The clocked inverter X11 serves as a level holding circuit for the inverted divided signal XQ. That is, when the clocked inverter X8 is in operation, the clocked inverter X11 is out of operation and the inverted signal of the signal M is output as the inverted divided signal XQ by the clocked inverter X8. On the other hand, when the clocked inverter X8 is out of operation, the clocked inverter X11 is in operation and the inverted signal of the divided signal Q is output as the inverted divided signal XQ by the clocked inverter X11. That is, when the clocked inverter X8 is out of operation, the level of the inverted divided signal X6 just before the clocked inverter X8 is out of operation is maintained by as the clocked inverter X11.

The output signal generator 30 generates an output signal OUT and an inverted signal XOUT (output signals OUT and XOUT) having the same frequency as that of the inverted divided signal XQ and having the locked phase on the basis of the inverted divided signal XQ generated by the divided signal generator 20. The output signal generator 30 includes clocked inverters X15 and X19 (clocked inverter) and inverters X16, X17, X18, X20, and X21.

The clocked inverter X15 receives the clock signal CLOCK as a control signal, inversely amplifies the inverted divided signal XQ, and outputs as a signal Mhold. The inverter X18 inversely amplifies and outputs the inverted divided signal XQ . The clocked inverter X19 receives the clock signal CLOCK as a control signal, inversely amplifies the output signal (that is, the inverted signal of the inverted divided signal XQ) of the inverter X18, and outputs as a signal XMhold.

That is, the inverted divided signal XQ is inversely amplified and is output as the signal Mhold by the clocked inverter X15, and is inversely amplified and is output as the signal Mhold by the inverter X18 and the clocked inverter X19 . Accordingly, the signals Mhold and XMhold have phases opposite to each other.

The clocked inverters X15 and X19 receive a common signal CLOCK as a control signal. That is, the timings of switching the in-operation state and the out-of-operation state of the clocked inverters X15 and X19 agree to each other and the change timings of the signals Mhold and XMhold thus agree to each other.

The signal Mhold is inversely amplified and is output as the output signal OUT by the inverters X16 and X17. The signal XMhold is inversely amplified and is output as the inverted output signal XOUT by the inverters X20 and X21.

The inverters X16 and X17 serve as a level holding circuit (level holder) for the signal Mhold. That is, when the clocked inverter X15 is out of operation, the output level of the signal Mhold just before the clocked inverter X15 is out of operation is maintained by the gate capacitors of transistors of the inverters X16 and X17 or the wiring capacitors.

The inverters X20 and X21 serve as a level holding circuit (level holder) for the signal XMhold. That is, when the clocked inverter X19 is out of operation, the output level of the signal XMhold just before the clocked inverter X19 is out of operation is maintained by the gate capacitors of transistors of the inverters X20 and X21 or the wiring capacitors.

### Operations

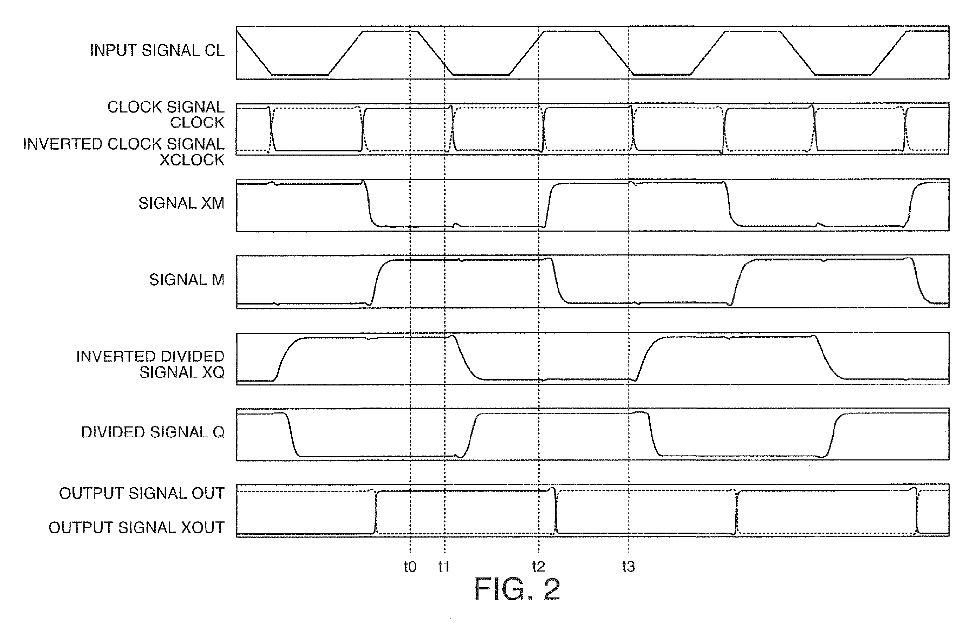

The operation of the division circuit 1 will be described below with reference to the signal waveforms. Fig. 2 is a diagram illustrating the signal waveforms in the division circuit 1. In Fig. 2, the horizontal axis represents the time t and the vertical axis represents the signal waveforms of the input signal CL, the clock signal CLOCK, the inverted clock signal XCLOCK, the signal XM, the signal M, the inverted divided signal XQ, the divided signal Q, and the output signals OUT and XOUT as signal levels sequentially from the upper end. The clock signal CLOCK and the output signal XOUT are marked by solid lines and the inverted clock signal XCLOCK and the output signal OUT are marked by broken lines.

First, at time t0, the clock signal CLOCK is at the "H" level, the inverted clock signal XCLOCK is at the "L" level, and the inverted divided signal XQ is at the "H" level.

At this time, the clocked inverter X6 is "in operation" and the clocked inverter X10 is "out of operation" . That is, the inverted signal of the inverted divided signal XQ is output as the signal XM by the clocked inverter X6 and the signal XM is at the "L" level. The inverted signal of the signal XM is output as the signal M by the inverter X7 and the signal M is at the "H" level.

The clocked inverter X8 is "out of operation" and the clocked inverter X11 is "in operation". That is, the inverted signal of the inverted divided signal XQ is output as the divided signal Q by the inverter X9 and the divided signal Q is at the "L" level. That is, the inverted signal of the divided signal Q is output as the inverted divided signal XQ by the clocked inverter X11 and the inverted divided signal XQ is maintained at the "H" level.

The clocked inverter X15 is "in operation" and the inverted signal of the inverted divided signal XQ is output as the signal Mhold by the clocked inverter X15. That is, the output signal OUT is at the "L" level. The clocked inverter X19 is "in operation" and the inverted signal of the output signal (the inverted signal of the inverted divided signal XQ) of the inverter X18 is output as the signal XMhold by the clocked inverter X19. That is, the inverted output signal XOUT is changed to the "H" level.

At time t1, when the clock signal CLOCK is changed from the "H" level to the "L" level and the inverted clock signal XCLOCK is changed from the "L" level to the "H" level, the clocked inverter X6 is "out of operation" and the clocked inverter X10 is "in operation". That is, the inverted signal of the signal M is output as the signal XM by the clocked inverter X10, the signal XM is maintained at the "L" level, and the signal M is maintained at the "H" level.

The clocked inverter X8 is "in operation" and the clocked inverter X11 is "out of operation,". That is, the inverted signal of the signal M is output as the inverted divided signal XQ by the clocked inverter X8 and the inverted divided signal XQ is changed from the "H" level to the "L" level. The inverted signal of the inverted divided signal XQ is output as the divided signal Q by the inverter X9 and the divided signal Q is changed from the "L" level to the "H" level. At this time, since the divided signal Q passes through the inverter X9, the divided signal Q is changed to the inverted signal XQ with a time delay.

The clocked inverters X15 and X19 are "out of operation". Accordingly, the level of the signal Mhold just before the clocked inverter X15 is "out of operation" is maintained by the inverters X16 and X1"7 and the output signal OUT is maintained at the "L" level. The level of the signal XMhold just before the clocked inverter X19 is "out of operation" is maintained by the inverters X20 and X21 and the inverted output signal XOUT is maintained at the "H" level.

At time t2, when the clock signal CLOCK is changed to the "L" level to the "H" level and the inverted clock signal XCLOCK is changed from the "H" level to the "L" level, the clocked inverter X6 is "in operation" and the clocked inverter X10 is "out of operation". That is, the inverted signal of the inverted divided signal XQ is output as the signal XM by the clocked inverter X6 and the signal XM is changed from the "L" level to the "H" level. The signal M is changed from the "H" level to the "L" level by the inverter X7. At this time, since the signal M passes through the inverter X7, the signal M is changed to the signal XM with a time delay.

The clocked inverter X8 is "out of operation" and the clocked inverter X11 is "in operation". That is, the inverted signal of the divided signal Q is output as the inverted divided signal XQ by the clocked inverter X11 and the level of the inverted divided signal XQ just before the clocked inverter X8 is out of operation is maintained. That is, the inverted divided signal XQ is maintained at the t`L" level and the divided signal Q is maintained at the "H" level.

The clocked inverters X15 and X19 are "in operation" . That is, the inverted signal of the inverted divided signal XQ is output as the signal Mhold by the clocked inverter X15. Accordingly, the signal Mhold is changed from the "L" level to the "H" level and the output signal OUT is changed from the "L" level to the "H" level. The inverted signal of the output signal of the inverter X18 is output as the signal XMhold by the clocked inverter X19. Accordingly, the signal XMhold is changed from the "H" level to the "L" level and the inverted output signal XOUT is changed from the "H" level to the "L" level.

Here, the in-operation state and the out-of-operation state of the clocked inverters X15 and X19 are switched in response to the common clock signal CLOCK. That is, the change timings of the signals Mhold and XMhold which are the output signals of the clocked inverters X15 and X19 almost agree to each other and the change timings of the output signals OUT and XOUT almost agree to each other.

Thereafter, the levels of the signals are changed similarly with the changes in level of the clock signals CLOCK and XCLOCK.

### Operational Advantages

In the division circuit 1 according to this embodiment, the output signals OUT and XOUT which have phases almost completely opposite to each other are output by the clocked inverters X15 and X19 of which the in-operation state and the out-of-operation state are switched in response to the common clock signal CLOCK.

### Modifications

The invention is not limited to the above-mentioned embodiment, but can be properly modified in various forms without departing from the concept of the invention.

### A. Connection of Plural Stages of Division Circuits 1

For example, when plural stages (N stages, where "N" is an integer equal to or greater than 2) of division circuits 1 (dividers) are cascaded to constitute a division device, the output signal OUT of the (n-1) th--stage division circuit 1 is input as the clock signal CLOCK of the next-stage (nth-stage) division circuit 1 and the output signal XOUT of the (n-1) th-stage division circuit 1 is input as the inverted clock signal XCLOCK of the next-stage (nth-stage) division circuit 1 (where, n= 2, 3, ..., N) . That is, in this case, the first-stage division circuit 1 includes the clock signal generator 10 (clock signal generator) but the second-stage or subsequent-stages division circuits 1 (n>2) may not include the clock signal generator 10 (clock signal generator).

### B. Addition of Set/Reset Circuit

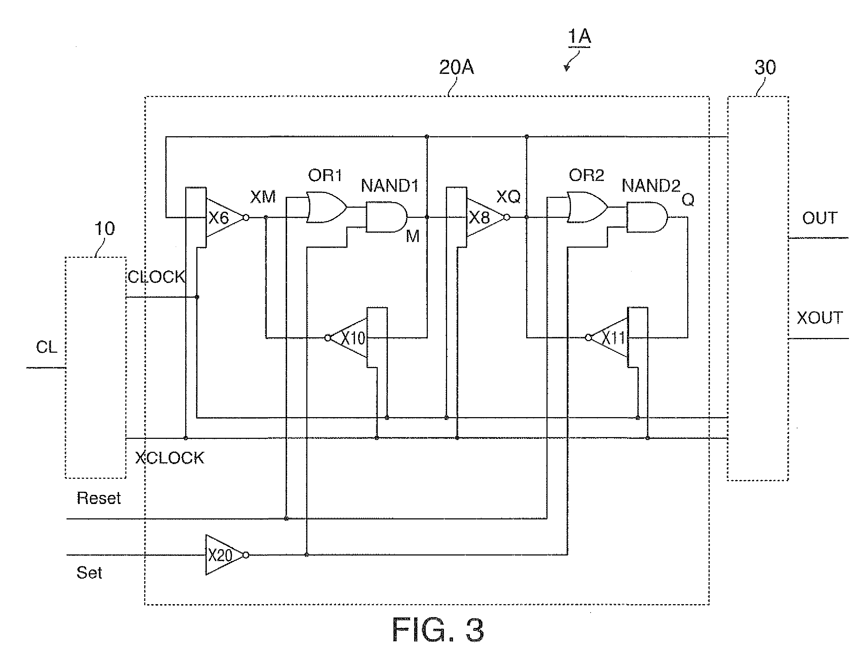

A circuit setting/resetting the signal M and the divided signal Q may be added to the division circuit 1. Fig. 3 is a diagram illustrating the circuit configuration of a division circuit 1A to which the set/reset circuit is added. The division circuit 1A has a configuration in which an OR gate OR1 and an NAND gate NAND1 are provided instead of the inverter X7 to the division circuit 1 shown in Fig. 1 and an OR gate OR2 and an NAND gate NAND2 are provided instead of the inverter X9. The same elements as those of the division circuit 1 shown in Fig. 1 are referenced by the same reference numerals and description thereof will not be repeated.

A signal XM and a reset signal Reset are input to the OR gate OR1. The output signal of the OR gate OR1 and the output signal of the inverter X20, that is, the inverted signal of the set signal Set, are input to the NAND gate NAND1. The output signal of the NAND gate NAND1 is the signal M. The inverted divided signal XQ and the reset signal Reset are input to the OR gate OR2. The output signal of the OR gate OR2 and the output signal of the inverter X20, that is, the inverted signal of the set signal Set, are input to the NAND gate NAND2. The output signal of the NAND gate NAND2 is the divided signal Q.

When the set signal Set and the reset signal Reset are both at the "L" level, the output signal of the OR gate OR1 is equal to the signal XM. The output signal of the NAND gate NAND1 is the inverted signal of the output signal of the OR gate OR1. That is, the OR gate OR1 and the NAND gate NAND operate similarly to the inverter X7. The output signal of the OR gate OR2 is equal to the divided signal Q. The output signal of the NAND gate NAND2 is the inverted signal of the output signal of the OR gate OR2. That is, the OR gate OR2 and the NAND gate NAND2 operate similarly to the inverter X9.

When the reset signal Reset is maintained at the "L" level and the set signal Set is changed to the "H" level, the output signals of the NAND gates NAND1 and NAND2 are changed to the "H" level regardless of the output signals of the OR gates OR1 and OR2 . That is, the signal M and the divided signal Q are set to the "H" level.

When the set signal Set is maintained at the "L" level and the reset signal Reset is changed to the "H" level, the output signals of the OR gates OR1 and OR2 are changed to the "H" level regardless of the signal XM and the inverted divided signal XQ . The output signals of the NAND gates NAND1 and NAND2 are changed to the "L" level. That is, the signal M and the divided signal Q are reset to the "L" level.

### C. Level Holder

In the division circuit 1 according to the above-mentioned embodiment, the level holders holding the levels of the signals Mhold and XMhold are embodied by the gate capacitors of the inverters X16, X17, X20, and X21 or the like. However, when the input signal CL is a low-frequency signal, the level holders may be embodied by capacitors instead.

## Claims

1. A division circuit comprising:
a division unit that generates a divided signal by dividing the frequency of an input signal on the basis of a clock signal having the same frequency as that of the input signal and an inverted clock signal being synchronized with the clock signal but having an inverted phase, of which both clock signals are generated from the input signal; and
an output signal generator that generates an output signal on the basis of the divided signal having the same frequency as that of the divided signal and an inverted output signal being synchronized with the output signal but having an inverted phase, of which both output signals are generated from the divided signal.

2. The division circuit according to claim 1, wherein the output signal generator includes a clocked inverter operating in response to the clock signal so as to lock the phase of the output signal and the phase of the inverted output signals.

3. The division circuit according to claim 2, wherein the output signal generator further includes a level holder that holds the output level of the clocked inverter.

4. The division circuit according to claim 3, wherein the level holder holds the output level by the use of a gate capacitor or a wiring capacitor of a transistor included in the level holder.

5. A division device in which N-stage (where N is an integer equal to or greater than 2) dividers are cascaded,
wherein the first-stage divider includes
a clock signal generator that generates a clock signal and an inverted clock signal on the basis of an input signal, and
the division circuit according to claim 1, and wherein the nth-stage (where n=2, 3, ..., N) divider includes the division circuit according to claim 1 that receives the output signal output from the (n-l)th-stage divider as the clock signal and receives the inverted output signal thereof as the inverted clock signal.

6. An electronic apparatus comprising the division circuit according to one or more of claims 1 to 4.

7. An electronic apparatus comprising the division device according to claim 5.
